# EUROPEAN PATENT APPLICATION

(11) **EP 3 920 222 A1**
(43) Date of publication of application: **08.12.2021**
(21) Application number: 20907931.8
(22) Date of filing: 22.10.2020
(51) Int. Cl.: H01L 25/16, H01L 21/98, H01L 23/31, H01L 21/50, H01L 21/56

(54) **SYSTEM-IN-PACKAGE STRUCTURE, AND PACKAGING METHOD FOR SAME**

(30) Priority: 27.12.2019 CN 201911390164
(71) Applicant: Huawei Technologies Co., Ltd., Shenzhen, Guangdong 518129 (CN)
(72) Inventor: BAO, Kuanming, Shenzhen, Guangdong 518129 (CN)
(74) Representative: Thun, Clemens
(86) International application number: PCT/CN2020/122789
(87) International publication number: WO 2021/129092

(57) **Abstract**

Embodiments of this application provide a system-in-package structure and a packaging method thereof. The system-in-package structure includes a carrier plate, a chip, a passive component, a first plastic package body and a second plastic package body. The chip is disposed on a first surface of the carrier plate, the passive component is disposed on a second surface of the carrier plate, and the first surface is disposed opposite to the second surface. The first plastic package body for packaging the chip is formed on the first surface, a surface that is of the chip and that is away from the carrier plate is exposed to the first plastic package body, and the second plastic package body for packaging the passive component is formed on the second surface. In the foregoing package structure, the chip that is a main heat source is packaged on one side of the carrier plate by the first plastic package body, and the passive component that has a comparatively poor correlation with the chip is packaged on another side of the carrier plate by the second plastic package body. In addition, the chip is exposed to the first plastic package body. Therefore, heat generated when the chip runs can be directly diffused outwards, thereby effectively improving heat dissipation performance of the entire system-in-package structure.

## Description

This application claims priority to Chinese Patent Application No. 201911390164.9, filed with the Chinese Patent Office on December 27, 2019 and entitled "SYSTEM-IN-PACKAGE STRUCTURE AND PACKAGING METHOD THEREOF", which is incorporated herein by reference in its entirety.

### TECHNICAL FIELD

This application relates to the field of electronic circuits, and in particular, to a system-in-package structure and a packaging method thereof.

### BACKGROUND

A system-in-package (System in Package) structure with features of a micro volume and low power consumption wraps a large quantity of electronic components such as capacitors, inductors, resistors, and lines into a quite small package, and may be widely applied to a wireless communication module, a portable communication product, and the like.

A conventional package structure usually includes a substrate, a passive component, a chip, and a plastic package body. The passive component and the chip are packaged on one surface of the substrate by the plastic package body, and the passive component and the chip are arranged in a flat manner. Because the passive component and the chip usually have a difference in height, the plastic package body also needs to have a comparatively large thickness, and heat generated by the chip is usually conducted in a direction toward the substrate, resulting in poor heat dissipation performance of the package structure.

### SUMMARY

Embodiments of this application provide a system-in-package structure and a packaging method thereof, so that heat generated when a chip runs can be directly diffused outwards, thereby effectively improving heat dissipation performance of the entire system-in-package structure.

A first aspect of the embodiments of this application provides a system-in-package structure, including: a carrier plate, a chip, a passive component, a first plastic package body and a second plastic package body. The carrier plate has a first surface and a second surface that are disposed oppositely. The chip is disposed on the first surface of the carrier plate, and the passive component is disposed on the second surface of the carrier plate, so that the chip that is a main heat source and the passive component that is not a main heat source are disposed on two sides of the carrier plate respectively. Further, the chip is packaged by the first plastic package body that is formed on the first surface, and a surface that is of the chip and that is away from the carrier plate is exposed to the first plastic package body. The passive component is packaged by the second plastic package body that is formed on the second surface. In this way, a complete package structure is formed.

In the foregoing system-in-package structure, the chip that is a main heat source is packaged on one side of the carrier plate by the first plastic package body, and the passive component that has a comparatively poor correlation with the chip is packaged on another side of the carrier plate by the second plastic package body. In addition, the chip is exposed to the first plastic package body. Therefore, heat generated when the chip runs can be directly diffused outwards, thereby effectively improving heat dissipation performance of the entire system-in-package structure.

With reference to the first aspect of the embodiments of this application, in a first implementation of the first aspect of the embodiments of this application, the surface that is of the chip and that is away from the carrier plate and a surface that is of the first plastic package body and that is away from the carrier plate are on a same plane, so that a surface of the entire system-in-package structure can be complete and smooth, which is beneficial to mounting and use.

With reference to the first aspect of the embodiments of this application or the first implementation of the first aspect, in a second implementation of the first aspect of the embodiments of this application, the system-in-package structure further includes an interconnecting component, where the interconnecting component is disposed on the second surface of the carrier plate, and the interconnecting component is packaged by the second plastic package body. This can improve a function and a structure of the system-in-package structure, thereby improving flexibility and selectivity of this solution.

With reference to the second implementation of the first aspect of the embodiments of this application, in a third implementation of the first aspect of the embodiments of this application, the system-in-package structure further includes: a pad, where the pad is disposed on a surface that is of the second plastic package body and that is away from the carrier plate, and the pad is electrically connected to the passive component and the interconnecting component separately. This can further improve the function and the structure of the system-in-package structure, thereby improving flexibility and selectivity of this method.

With reference to the second implementation or the third implementation of the first aspect of the embodiments of this application, in a fourth implementation of the first aspect of the embodiments of this application, the carrier plate is a substrate including a metal layer, and the chip, the passive component, and the interconnecting component are electrically connected by using the metal layer. This improves flexibility and selectivity of the method.

With reference to the second implementation or the third implementation of the first aspect of the embodiments of this application, in a fifth implementation of the first aspect of the embodiments of this application, the carrier plate is a metal frame, and the chip, the passive component, and the interconnecting component are electrically connected by using the metal frame. This improves flexibility and selectivity of the method.

A second aspect of the embodiments of this application provides a packaging method of a system-in-package structure, where the packaging method includes:
mounting a chip on a first surface of a carrier plate, and plastic packaging the chip to form a first plastic package body on the first surface, where a surface that is of the chip and that is away from the carrier plate is exposed to the first plastic package body; and
mounting a passive component on a second surface of the carrier plate, and plastic packaging the passive component to form a second plastic package body on the second surface, where the first surface is disposed opposite to the second surface.

In the foregoing system-in-package structure formed according to the packaging method, the chip that is a main heat source is packaged on one side of the carrier plate by the first plastic package body, and the passive component that has a comparatively poor correlation with the chip is packaged on another side of the carrier plate by the second plastic package body. In addition, the chip is exposed to the first plastic package body. Therefore, heat generated when the chip runs can be directly diffused outwards, thereby effectively improving heat dissipation performance of the entire system-in-package structure.

With reference to the second aspect of the embodiments of this application, in a first implementation of the second aspect of the embodiments of this application, the surface that is of the chip and that is away from the carrier plate and a surface that is of the first plastic package body and that is away from the carrier plate are on a same plane, so that a surface of the entire system-in-package structure can be complete and smooth, which is beneficial to mounting and use.

With reference to the first implementation of the second aspect of the embodiments of this application, in a second implementation of the second aspect of the embodiments of this application, the mounting a passive component on a second surface of the carrier plate includes:
mounting the passive component and an interconnecting component on the second surface of the carrier plate.

In the foregoing implementation, on a basis that the passive component is mounted on the second surface of the carrier plate, the interconnecting component is further mounted on the second surface. This can improve a function of the system-in-package structure, thereby improving flexibility and selectivity of this solution.

With reference to the second implementation of the second aspect of the embodiments of this application, in a third implementation of the second aspect of the embodiments of this application, the plastic packaging the passive component to form a second plastic package body on the second surface includes:
plastic packaging the passive component and the interconnecting component to form the second plastic package body on the second surface.

In the foregoing implementation, both the passive component and the interconnecting component are packaged on the second surface of the carrier plate by the second plastic package body. This can improve a structure of the system-in-package structure, thereby improving flexibility and selectivity of this solution.

With reference to the third implementation of the second aspect of the embodiments of this application, in a fourth implementation of the second aspect of the embodiments of this application, after the plastic packaging the passive component and the interconnecting component to form the second plastic package body on the second surface, the packaging method further includes:
performing electroplating on a surface that is of the second plastic package body and that is away from the carrier plate, to form a pad on the surface that is of the second plastic package body and that is away from the carrier plate, where the pad is electrically connected to the passive component and the interconnecting component separately.

In the foregoing implementation, electroplating is performed on the surface that is of the second plastic package body and that is away from the carrier plate, to form the pad that is electrically connected to the passive component and the interconnecting component. This can further improve the function and the structure of the system-in-package structure, thereby improving flexibility and selectivity of this method.

With reference to the third implementation of the second aspect of the embodiments of this application, in a fifth implementation of the second aspect of the embodiments of this application, after the plastic packaging the passive component and the interconnecting component to form the second plastic package body on the second surface, the packaging method further includes:
soldering metal on a surface that is of the second plastic package body and that is away from the carrier plate, to form a pad on the surface that is of the second plastic package body and that is away from the carrier plate, where the pad is electrically connected to the passive component and the interconnecting component separately.

In the foregoing implementation, the metal is soldered on the surface that is of the second plastic package body and that is away from the carrier plate, to form the pad that is electrically connected to the passive component and the interconnecting component. This can further improve the function and the structure of the system-in-package structure, thereby improving flexibility and selectivity of this method.

With reference to any one of the third implementation to the fifth implementation of the second aspect of the embodiments of this application, in a sixth implementation of the second aspect of the embodiments of this application, the carrier plate is a substrate including a metal layer, and the chip, the passive component, and the interconnecting component are electrically connected by using the metal layer. Alternatively, the carrier plate is a metal frame, and the chip, the passive component, and the interconnecting component are electrically connected by using the metal frame. This improves flexibility and selectivity of this solution.

A third aspect of the embodiments of this application provides a packaging method of a system-in-package structure, where the packaging method includes:
mounting a passive component in a first inner cavity of a second plastic package body, and press-fitting a carrier plate with the second plastic package body, where a second surface of the carrier plate faces toward an opening of an inner cavity of the second plastic package body; and
mounting a chip on a first surface of the carrier plate, and plastic packaging the chip to form a first plastic package body on the first surface, where the first surface is disposed opposite to the second surface, and a surface that is of the chip and that is away from the carrier plate is exposed to the first plastic package body.

In the foregoing system-in-package structure formed according to the packaging method, the chip that is a main heat source is packaged on one side of the carrier plate by the first plastic package body, and the passive component that has a comparatively poor correlation with the chip is packaged on another side of the carrier plate by the second plastic package body. In addition, the chip is exposed to the first plastic package body. Therefore, heat generated when the chip runs can be directly diffused outwards, thereby effectively improving heat dissipation performance of the entire system-in-package structure.

With reference to the third aspect of the embodiments of this application, in a first implementation of the third aspect of the embodiments of this application, the surface that is of the chip and that is away from the carrier plate and a surface that is of the first plastic package body and that is away from the carrier plate are on a same plane, so that a surface of the entire system-in-package structure can be complete and smooth, which is beneficial to mounting and use.

With reference to the first implementation of the third aspect of the embodiments of this application, in a second implementation of the third aspect of the embodiments of this application, the packaging method further includes:
mounting an interconnecting component in a second inner cavity of the second plastic package body.

In the foregoing implementation, on a basis that the passive component is mounted in the first inner cavity of the second plastic package body, the interconnecting component is further mounted in the second inner cavity of the second plastic package body. This can improve a function of the system-in-package structure, thereby improving flexibility and selectivity of this solution.

With reference to the second implementation of the third aspect of the embodiments of this application, in a third implementation of the third aspect of the embodiments of this application, after the plastic packaging the chip to form a first plastic package body on the first surface, the packaging method further includes:
performing electroplating on a surface that is of the second plastic package body and that is away from the carrier plate, to form a pad on the surface that is of the second plastic package body and that is away from the carrier plate, where the pad is electrically connected to the passive component and the interconnecting component separately.

In the foregoing implementation, electroplating is performed on the surface that is of the second plastic package body and that is away from the carrier plate, to form the pad that is electrically connected to the passive component and the interconnecting component. This can further improve the function and a structure of the system-in-package structure, thereby improving flexibility and selectivity of this method.

With reference to the second implementation of the third aspect of the embodiments of this application, in a fourth implementation of the third aspect of the embodiments of this application, after the plastic packaging the chip to form a first plastic package body on the first surface, the packaging method further includes:
soldering metal on a surface that is of the second plastic package body and that is away from the carrier plate, to form a pad on the surface that is of the second plastic package body and that is away from the carrier plate, where the pad is electrically connected to the passive component and the interconnecting component separately.

In the foregoing implementation, the metal is soldered on the surface that is of the second plastic package body and that is away from the carrier plate, to form the pad that is electrically connected to the passive component and the interconnecting component. This can further improve the function and the structure of the system-in-package structure, thereby improving flexibility and selectivity of this method.

With reference to any one of the second implementation to the fourth implementation of the third aspect of the embodiments of this application, in a sixth implementation of the second aspect of the embodiments of this application, the carrier plate is a substrate including a metal layer, and the chip, the passive component, and the interconnecting component are electrically connected by using the metal layer. Alternatively, the carrier plate is a metal frame, and the chip, the passive component, and the interconnecting component are electrically connected by using the metal frame. This improves flexibility and selectivity of this solution.

It can be learned from the foregoing technical solutions that the embodiments of this application have the following advantages.

Embodiments of this application provide a system-in-package structure and a packaging method thereof. The system-in-package structure includes a carrier plate, a chip, a passive component, a first plastic package body and a second plastic package body. The chip is disposed on a first surface of the carrier plate, the passive component is disposed on a second surface of the carrier plate, and the first surface is disposed opposite to the second surface. The first plastic package body for packaging the chip is formed on the first surface, a surface that is of the chip and that is away from the carrier plate is exposed to the first plastic package body, and the second plastic package body for packaging the passive component is formed on the second surface. In the foregoing package structure, the chip that is a main heat source is packaged on one side of the carrier plate by the first plastic package body, and the passive component that has a comparatively poor correlation with the chip is packaged on another side of the carrier plate by the second plastic package body. In addition, the chip is exposed to the first plastic package body. Therefore, heat generated when the chip runs can be directly diffused outwards, thereby effectively improving heat dissipation performance of the entire system-in-package structure.

### BRIEF DESCRIPTION OF DRAWINGS

FIG. 1 is a schematic structural diagram of a system-in-package structure according to an embodiment of this application;
FIG. 2 is a schematic flowchart of a packaging method of a system-in-package structure according to an embodiment of this application;
FIG. 3 is a schematic diagram of an application example of a packaging method of a system-in-package structure according to an embodiment of this application;
FIG. 4 is another schematic flowchart of a packaging method of a system-in-package structure according to an embodiment of this application; and
FIG. 5 is a schematic diagram of another application example of a packaging method of a system-in-package structure according to an embodiment of this application.

### DESCRIPTION OF EMBODIMENTS

The following describes in detail the technical solutions in the embodiments of this application with reference to the accompanying drawings in the embodiments of this application.

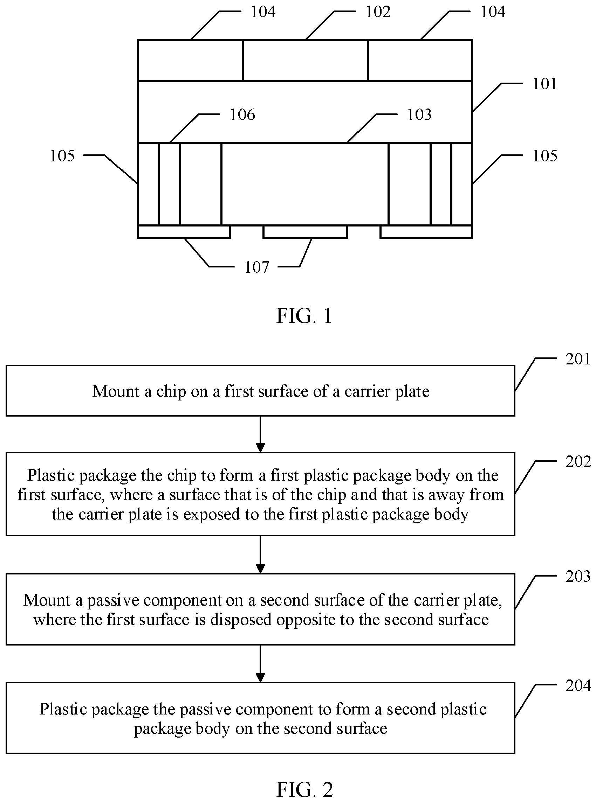

FIG. 1 is a schematic structural diagram of a system-in-package structure according to an embodiment of this application. Referring to FIG. 1, the system-in-package structure includes: a carrier plate 101, a chip 102, a passive component 103, a first plastic package body 104, and a second plastic package body 105.

The carrier plate 101 has a first surface and a second surface that are disposed oppositely. The chip 102 is disposed on the first surface of the carrier plate 101, and the passive component 103 is disposed on the second surface of the carrier plate 101, so that the chip 102 and the passive component 103 are disposed on two sides of the carrier plate respectively.

To make the entire package structure more stable, the chip 102 and the passive component 103 may be separately packaged by a plastic package body. The first plastic package body 104 for packaging the chip 102 is formed on the first surface. It should be noted that a surface that is of the chip 102 and that is away from the carrier plate 101 is exposed to the first plastic package body 104. Therefore, when the chip 102 is in a working state, heat generated by the chip 102 can be directly diffused outwards (for example, the heat is discharged in an upward direction in FIG. 1). In addition, the surface that is of the chip 102 and that is away from the carrier plate 101 may be connected to a heat sink to effectively diffuse the heat generated by the chip 102. The second plastic package body 105 for packaging the passive component 103 is formed on the second surface. Therefore, the first plastic package body 104 fastens the chip 102 on one side of the carrier plate 101, and the second plastic package body 105 fastens the passive component 103 on another side of the carrier plate 101, so that a structure of the entire package structure is stable and hierarchical.

In this embodiment, the chip 102 that is a main heat source is packaged on one side of the carrier plate 101 by the first plastic package body 104, and the passive component 103 (such as a resistor, an inductor, and a capacitor) that has a comparatively poor correlation with the chip 102 is packaged on another side of the carrier plate 101 by the second plastic package body 105. In addition, the chip 102 is exposed to the first plastic package body 104. Therefore, the heat generated when the chip 102 runs can be directly diffused outwards, thereby effectively improving heat dissipation performance of the entire system-in-package structure.

In a possible implementation, the chip 102 has two surfaces that are disposed oppositely. One surface is close to the carrier plate 101, and the other surface is away from the carrier plate 101. To make a surface of the package structure complete and smooth, the surface that is away from the carrier plate 101 and a surface that is of the first plastic package body 104 and that is away from the carrier plate 101 (The first plastic package body 104 includes a surface that contacts the carrier plate 101 and the surface that is away from the carrier plate 101) may be on a same plane. Therefore, the surfaces of the chip 101 and the surfaces of the first plastic package body 104 form a complete and smooth plane, which is beneficial to mounting and use of the entire package structure.

In a possible implementation, the carrier plate 101 is a substrate including a metal layer. Specifically, the substrate may be composed of a plastic package body. In addition, the plastic package body is electroplated, so that a metal layer with specific cabling is formed inside the plastic package body. Therefore, any two of the chip 102, the passive component 103, and an interconnecting component 106 that are separately disposed on two sides of the substrate may be electrically connected by using the metal layer.

In a possible implementation, the carrier plate 101 is a metal frame. Therefore, any two of the chip 102, the passive component 103, and the interconnecting component 106 that are separately disposed on two sides of the metal frame may be electrically connected by using the metal frame.

In a possible implementation, the system-in-package structure further includes: the interconnecting component 106, where the interconnecting component 106 is disposed on the second surface of the carrier plate 101 and packaged by the second plastic package body 105. Specifically, the interconnecting component 106 may have a function of connection. Because the interconnecting component 106 is disposed on the second surface, the chip 102 may first be connected to the interconnecting component through the carrier plate 101, and then electrically connected to a component on an external circuit through the interconnecting component 106, to implement interaction between the chip 102 and the external circuit. Still further, to facilitate production and manufacturing, a shape of the interconnecting component 106 may be usually designed as a cylinder with a high aspect ratio. It should be understood that the shape of the interconnecting component 106 may be designed based on an actual requirement, which is not specifically limited herein.

In a possible implementation, the system-in-package structure further includes: a pad 107, where the pad 107 is disposed on a surface that is of the second plastic package body 105 and that is away from the carrier plate (The second plastic package body 105 includes a surface that contacts the carrier plate 101 and the surface that is away from the carrier plate 101). The pad 107 is electrically connected to the passive component 103 and the interconnecting component 106 separately. Specifically, the pad 107 is made of metal. Therefore, the pad 107 disposed on the surface of the second plastic package body 105 may be electrically connected to the passive component 103 and the interconnecting component 106 separately that are in the second plastic package body 105, to serve as a connection point for interaction between the passive component 103, the interconnecting component 106 and the external circuit.

In a possible implementation, to meet different functional requirements for the package structure in actual application, an electronic component (not shown in FIG. 1) having a comparatively strong correlation with the chip 102 may further be disposed on the first surface of the carrier plate 101. A comparatively small amount of heat is generated when the electronic component works, and the electronic component is not a main heat source. In addition, a height of the electronic component is less than or equal to a height of the chip, and the electronic component is covered by the first plastic package body 104.

In a possible implementation, the first plastic package body 104, the second plastic package body 105, and the plastic package body forming the carrier plate 101 each may be made of a resin material.

In a possible implementation, the interconnecting component may be made of metal or a semiconductor (such as silicon, carbide, and gallium nitride).

In a possible implementation, the package structure in this application includes at least two layers of structures. One layer includes the first plastic package body and a component packaged by the first plastic package body, and the other layer includes the second plastic package body and a component packaged by the second plastic package body. In addition, an additional carrier plate may further be disposed on the surface that is of the second plastic package body 105 and that is away from the carrier plate, so that another component is further to be disposed and packaged on the additional carrier plate. In this way, a package structure with a structure including at least three layers is formed.

In the system-in-package structure provided in this embodiment of this application, the chip 102 that is a main heat source is exposed to the first plastic package body 104, so that the heat generated by the chip 102 can be directly diffused outwards, thereby effectively improving heat dissipation performance of a package module. Still further, two layers of cabling (one layer is metal cabling in the carrier plate, and the other layer is metal cabling in the pad) are formed by separately disposing the components on two sides of the carrier plate 101. Superposed layers are interconnected, so that an integration degree of the package structure can be improved and an area of the package structure can be reduced.

The foregoing is a specific description of the system-in-package structure provided in the embodiments of this application. The following describes a packaging method of the system-in-package structure provided in the embodiments of this application. FIG. 2 is a schematic flowchart of a packaging method of a system-in-package structure according to an embodiment of this application. Referring to FIG. 2, the method includes the following steps.

201: Mount a chip on a first surface of a carrier plate.

In this embodiment, a carrier plate may be first prepared, and the carrier plate may be a substrate including a metal layer, or may be a metal frame. For specific description, refer to related descriptions of the embodiment corresponding to FIG. 1, and details are not described herein again. After the carrier plate is prepared, the chip is mounted on the first surface of the carrier plate.

202: Plastic package the chip to form a first plastic package body on the first surface, where a surface that is of the chip and that is away from the carrier plate is exposed to the first plastic package body.

After the chip is mounted on the first surface of the carrier plate, the chip may be plastic packaged to form the first plastic package body on the first surface. Optionally, the plastic packaging the chip to form the first plastic package body on the first surface includes: disposing a film on the surface that is of the chip and that is away from the carrier plate, injecting a plastic package body between the film and the first surface to form the first plastic package body on the first surface, and removing the film from the chip. It should be noted that the first plastic package body surrounds only a periphery of the chip, so that the surface that is of the chip and that is away from the carrier plate (that is, a back of the chip) is exposed to the first plastic package body. Optionally, to make a surface of the package structure complete and smooth, the surface that is away from the carrier plate and a surface that is of the first plastic package body and that is away from the carrier plate may be on a same plane. Therefore, the chip and the surface that is of the first plastic package body and that is away from the carrier plate form a complete and smooth plane, which is beneficial to mounting and use of the entire package structure.

203: Mount a passive component on a second surface of the carrier plate, where the first surface is disposed opposite to the second surface.

After the carrier plate is prepared, the passive component may further be mounted on the second surface of the carrier plate, where the first surface and the second surface are two surfaces that are disposed oppositely on the carrier plate.

204: Plastic package the passive component to form a second plastic package body on the second surface.

After the passive component is mounted on the second surface of the carrier plate, the passive component may be plastic packaged to form the second plastic package body on the second surface. The passive component may be packaged in a plurality of manners. For example, the passive component is covered by the second plastic package body. For another example, the second plastic package body only surrounds a periphery of the passive component. In other words, a surface that is of the passive component and that is away from the carrier plate is exposed to the second plastic package body, and the like. The packaging manner can be designed accordingly based on an actual requirement. In this way, the first plastic package body and the second plastic package body respectively fasten the chip and the passive component on two sides of the carrier plate, so that a structure of the entire package structure is complete and hierarchical.

It should be understood that an order of the steps shown in FIG. 2 is merely an example for description, and does not constitute a limitation on an execution order of step 201 and step 203. For example, step 201 may be performed before step 203; for another example, step 203 may be performed before step 201; for another example, step 201 and step 203 are performed simultaneously; and the like.

In the foregoing system-in-package structure formed according to the packaging method, the chip that is a main heat source is packaged on one side of the carrier plate by the first plastic package body, and the passive component that has a comparatively poor correlation with the chip is packaged on another side of the carrier plate by the second plastic package body. In addition, the chip is exposed to the first plastic package body. Therefore, heat generated when the chip runs can be directly diffused outwards, thereby effectively improving heat dissipation performance of the entire system-in-package structure.

Still further, two layers of cabling are formed by separately disposing the components on two sides of the carrier plate. Superposed layers are interconnected, so that an integration degree of the package structure can be improved and an area of the package structure can be reduced.

Based on the embodiment corresponding to FIG. 2, in an optional embodiment of the packaging method provided in this embodiment of this application, the mounting the passive component on the second surface of the carrier plate includes:
mounting the passive component and an interconnecting component on the second surface of the carrier plate.

Still further, the plastic packaging the passive component to form the second plastic package body on the second surface includes:
plastic packaging the passive component and the interconnecting component to form the second plastic package body on the second surface.

In this embodiment, after the carrier plate is prepared, both the passive component and the interconnecting component may be mounted on the second surface of the carrier plate. Optionally, the mounting the interconnecting component on the second surface of the carrier plate includes: first obtaining a mold having a pre-positioned through hole (A shape of the pre-positioned through hole is a shape of the interconnecting component), then fastening the mold on the second surface of the carrier plate, injecting a semiconductor or liquid metal into the pre-positioned through hole to form the interconnecting component in the pre-positioned through hole, and then removing the mold to complete mounting of the interconnecting component on the carrier plate. After being mounted, the passive component and the interconnecting component are plastic packaged simultaneously to form the second plastic package body on the second surface of the carrier plate. It should be noted that, for a function and a structure of the interconnecting component, refer to related descriptions in the embodiment corresponding to FIG. 1. Details are not described herein again. The passive component and the interconnecting component may be packaged in a plurality of manners. For example, the passive component and the interconnecting component are covered by the second plastic package body. For another example, the second plastic package body only surrounds the periphery of the passive component and a periphery of the interconnecting component. In other words, the surface that is of the passive component and that is away from the carrier plate is exposed to the second plastic package body, and an end that is of the interconnecting component and that is away from the carrier plate is exposed to the second plastic package body, and the like. The packaging manner can be designed accordingly based on an actual requirement.

Based on the embodiments corresponding to FIG. 2, in an optional embodiment of the packaging method provided in this embodiment of this application, after the plastic packaging the passive component and the interconnecting component to form the second plastic package body on the second surface, the packaging method further includes:
performing electroplating on a surface that is of the second plastic package body and that is away from the carrier plate, to form a pad on the surface that is of the second plastic package body and that is away from the carrier plate, where the pad is electrically connected to the passive component and the interconnecting component separately.

In this embodiment, after the second plastic package body is formed, electroplating may be performed on the surface that is of the second plastic package body and that is away from the carrier plate, to form the pad on the surface that is of the second plastic package body and that is away from the carrier plate, where the pad is electrically connected to the passive component and the interconnecting component separately. It should be noted that, for a function of the pad, refer to related descriptions in the embodiment corresponding to FIG. 1. Details are not described herein again. It should be noted that if the passive component and the interconnecting component are covered by the second plastic package body, an area corresponding to the passive component and the interconnecting component may be melted on the surface that is of the second plastic package body and that is away from the carrier plate, so that the passive component and the interconnecting component are exposed. Therefore, the pad formed through electroplating can be electrically connected to the passive component and the interconnecting component.

Based on the embodiments corresponding to FIG. 2, in an optional embodiment of the packaging method provided in this embodiment of this application, after the plastic packaging the passive component and the interconnecting component to form the second plastic package body on the second surface, the packaging method further includes:
soldering metal on a surface that is of the second plastic package body and that is away from the carrier plate, to form a pad on the surface that is of the second plastic package body and that is away from the carrier plate, where the pad is electrically connected to the passive component and the interconnecting component separately.

In this embodiment, after the second plastic package body is formed, metal may be soldered on the surface that is of the second plastic package body and that is away from the carrier plate, to form the pad on the surface that is of the second plastic package body and that is away from the carrier plate, where the pad is electrically connected to the passive component and the interconnecting component separately. It should be noted that, for a function of the pad, refer to related descriptions in the embodiment corresponding to FIG. 1. Details are not described herein again. It should be noted that if the passive component and the interconnecting component are covered by the second plastic package body, an area corresponding to the passive component and the interconnecting component may be melted on the surface that is of the second plastic package body and that is away from the carrier plate, so that the passive component and the interconnecting component are exposed. In addition, metal is soldered in the area, so that the formed pad can be electrically connected to the passive component and the interconnecting component.

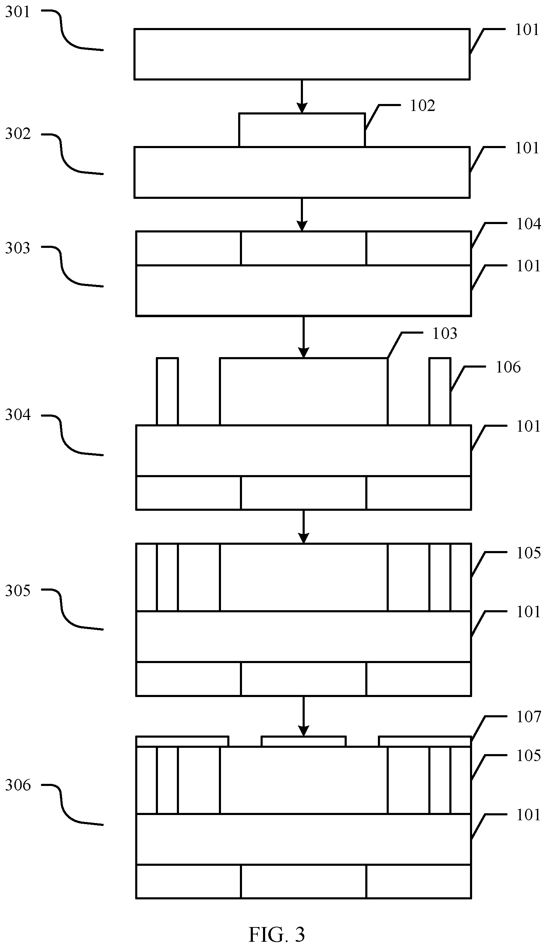

For ease of understanding, the packaging method corresponding to FIG. 2 is further described in the following with reference to FIG. 3. FIG. 3 is a schematic diagram of an application example of a packaging method of a system-in-package structure according to an embodiment of this application. The application example includes the following steps.

301: Prepare a carrier plate 101.

302: Mount a chip 102 and an electronic component having a comparatively strong correlation with the chip 102 on a surface of the carrier plate 101.

303: Plastic package the chip 102 and the electronic component having a comparatively strong correlation with the chip to form a first plastic package body 104, and expose an upper surface of the chip 102.

304: Flip the carrier plate 101, and mount an interconnecting component 106 and a passive component 103 having a comparatively poor correlation with the chip 102 on another surface of the carrier plate 101.

305: Plastic package the interconnecting component 106 and the passive component 103 having a comparatively poor correlation with the chip 102 to form a second plastic package body 105.

306: Perform electroplating or solder metal on a surface that is of the second plastic package body 105 and that is away from the carrier plate 101 to form a pad 107.

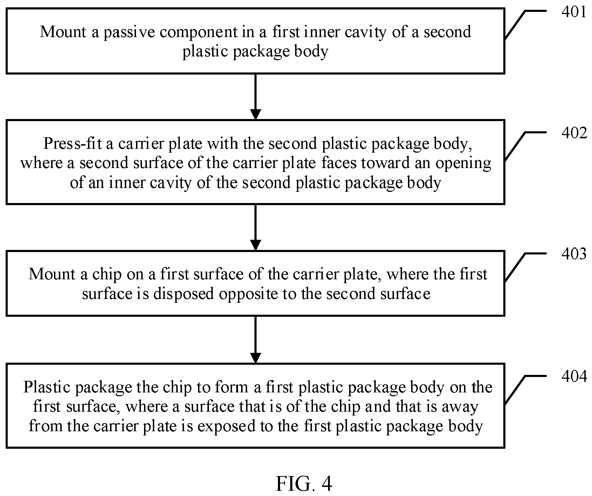

FIG. 4 is another schematic flowchart of a packaging method of a system-in-package structure according to an embodiment of this application. Referring to FIG. 4, the packaging method includes the following steps.

401: Mount a passive component in a first inner cavity of a second plastic package body.

In this embodiment, a second plastic package body is first prepared. It should be noted that the second plastic package body has a first inner cavity for mounting a passive component, and the first inner cavity has only one opening. Therefore, after the second plastic package body is obtained, the passive component that has a comparatively poor correlation with a chip may be mounted in the first inner cavity. The second plastic package body with an inner cavity may be manufactured in a plurality of manners. Optionally, a layer of a third plastic package body may be obtained first, a through hole is opened in a pre-positioned area of the third plastic package body, and a layer of a fourth plastic package body is press-fitted at the bottom of the third plastic package body, so that the third plastic package body and fourth plastic package body form the second plastic package body with the inner cavity.

402: Press-fit a carrier plate with the second plastic package body, where a second surface of the carrier plate faces toward an opening of an inner cavity of the second plastic package body.

After the passive component is mounted in the second plastic package body, the carrier plate may be press-fitted with the second plastic package body, so that the second surface of the carrier plate shields the opening of the inner cavity of the second plastic package body. To be specific, along a direction of the second surface toward the opening of the inner cavity of the second plastic package body, the carrier plate is press-fitted with the second plastic package body, to package the passive component in the second plastic package body.

403: Mount a chip on a first surface of the carrier plate, where the first surface is disposed opposite to the second surface.

After the carrier plate is press-fitted with the second plastic package body, the chip may be mounted on the first surface of the carrier plate, where the first surface is disposed opposite to the second surface.

404: Plastic package the chip to form a first plastic package body on the first surface, where a surface that is of the chip and that is away from the carrier plate is exposed to the first plastic package body.

After the chip is mounted on the first surface of the carrier plate, the chip may be plastic packaged to form the first plastic package body on the first surface. It should be noted that the first plastic package body only surrounds a periphery of the chip, so that the surface that is of the chip and that is away from the carrier plate (that is, a back of the chip) is exposed to the first plastic package body. Optionally, to make a surface of the package structure complete and smooth, the surface that is away from the carrier plate and a surface that is of the first plastic package body and that is away from the carrier plate may be on a same plane. Therefore, the chip and the surface that is of the first plastic package body and that is away from the carrier plate form a complete and smooth plane, which is beneficial to mounting and use of the entire package structure.

In the foregoing system-in-package structure formed according to the packaging method, the chip that is a main heat source is packaged on one side of the carrier plate by the first plastic package body, and the passive component that has a comparatively poor correlation with the chip is packaged on another side of the carrier plate by the second plastic package body. In addition, the chip is exposed to the first plastic package body. Therefore, heat generated when the chip runs can be directly diffused outwards, thereby effectively improving heat dissipation performance of the entire system-in-package structure.

Still further, two layers of cabling are formed by separately disposing the components on two sides of the carrier plate. Superposed layers are interconnected, so that an integration degree of the package structure can be improved and an area of the package structure can be reduced.

Based on the embodiment corresponding to FIG. 4, in an optional embodiment of the packaging method provided in this embodiment of this application, the packaging method further includes:
mounting an interconnecting component in a second inner cavity of the second plastic package body.

In this embodiment, the second plastic package body further has the second inner cavity for mounting the interconnecting component. The second inner cavity and the first inner cavity are disposed in parallel, and an opening direction of the second inner cavity is the same as an opening direction of the first inner cavity. Therefore, after the second plastic package body is obtained, the passive component may be mounted in the first inner cavity, and the interconnecting component may be mounted in the second inner cavity. It should be noted that a size of the first inner cavity is usually matched with the passive component, and a size of the second inner cavity is usually matched with the interconnecting component. To meet a mounting requirement, a size of an inner cavity is usually slightly larger than a size of a component (a passive component or an interconnecting component). If there is still a gap in a corresponding inner cavity after the passive component or the interconnecting component is mounted, a plastic package body may further be filled into the gap of the inner cavity, so that the second plastic package body can cover the passive component or the interconnecting component. After the carrier plate is press-fitted with the second plastic package body, it means that the passive component or the interconnecting component is packaged on the second surface of the carrier plate by the second plastic package body.

Based on the embodiments corresponding to FIG. 4, in an optional embodiment of the packaging method provided in this embodiment of this application, after the passive component and the interconnecting component are plastic packaged to form the second plastic package body on the second surface, the packaging method further includes:
performing electroplating on a surface that is of the second plastic package body and that is away from the carrier plate, to form a pad on the surface that is of the second plastic package body and that is away from the carrier plate, where the pad is electrically connected to the passive component and the interconnecting component separately.

In this embodiment, after the second plastic package body is formed, electroplating may be performed on the surface that is of the second plastic package body and that is away from the carrier plate, to form the pad on the surface that is of the second plastic package body and that is away from the carrier plate, where the pad is electrically connected to the passive component and the interconnecting component separately. It should be noted that, for a function of the pad, refer to related descriptions in the embodiment corresponding to FIG. 1. Details are not described herein again. It should be noted that because the passive component and the interconnecting component are covered by the second plastic package body, an area corresponding to the passive component and the interconnecting component may be melted on the surface that is of the second plastic package body and that is away from the carrier plate, so that the passive component and the interconnecting component are exposed. Therefore, the pad formed through electroplating can be electrically connected to the passive component and the interconnecting component.

Based on the embodiments corresponding to FIG. 4, in an optional embodiment of the packaging method provided in this embodiment of this application, after the passive component and the interconnecting component are plastic packaged to form the second plastic package body on the second surface, the packaging method further includes:
soldering metal on a surface that is of the second plastic package body and that is away from the carrier plate, to form a pad on the surface that is of the second plastic package body and that is away from the carrier plate, where the pad is electrically connected to the passive component and the interconnecting component separately.

In this embodiment, after the second plastic package body is formed, metal may be soldered on the surface that is of the second plastic package body and that is away from the carrier plate, to form the pad on the surface that is of the second plastic package body and that is away from the carrier plate, where the pad is electrically connected to the passive component and the interconnecting component separately. It should be noted that, for a function of the pad, refer to related descriptions in the embodiment corresponding to FIG. 1. Details are not described herein again. It should be noted that because the passive component and the interconnecting component are covered by the second plastic package body, an area corresponding to the passive component and the interconnecting component may be melted on the surface that is of the second plastic package body and that is away from the carrier plate, so that the passive component and the interconnecting component are exposed. In addition, metal is soldered in the area, so that the formed pad can be electrically connected to the passive component and the interconnecting component.

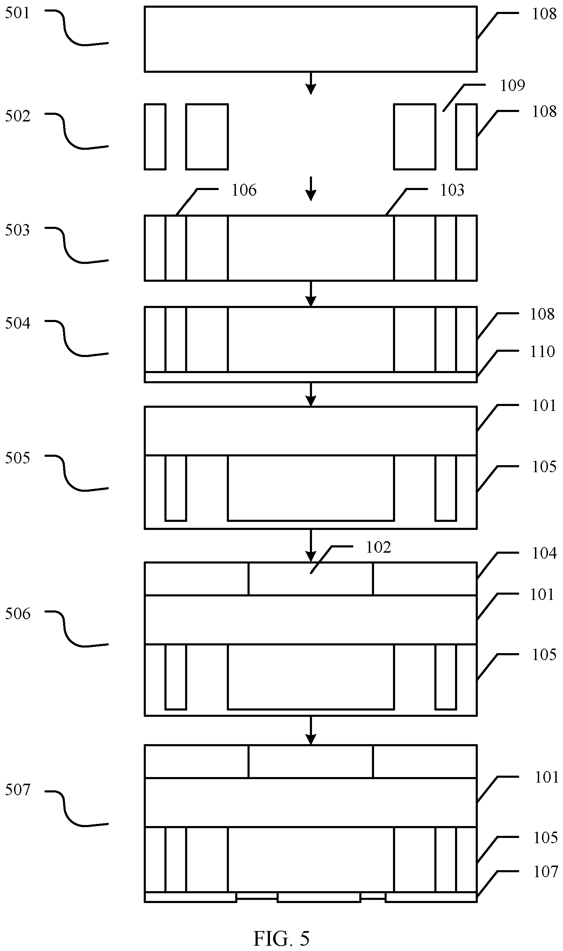

For ease of understanding, the packaging method corresponding to FIG. 4 is further described in the following with reference to FIG. 5. FIG. 5 is a schematic diagram of another application example of a packaging method of a system-in-package structure according to an embodiment of this application. The application example includes the following steps.

501: Prepare a layer of a third plastic package body 108.

502: Open a through hole 109 in a pre-positioned area of the third plastic package body 108.

503: Mount a passive component 103 and an interconnecting component 106 in the corresponding through hole 109.

504: Press-fit a fourth plastic package body 110 at the bottom of the third plastic package body 108, so that the third plastic package body 108 and the fourth plastic package body 110 form a second plastic package body 105 with an inner cavity.

It should be understood that step 504 may also be performed before step 503, and if step 504 is performed before step 503, step 503 may be: Mount the passive component and the interconnecting component in a corresponding inner cavity.

505: Press-fit a fifth plastic package body on the top of the third plastic package body 108, and electroplate a metal layer in the fifth plastic package body, where the fifth plastic package body and the metal layer form a carrier plate 101.

506: Mount a chip 102 at the top of the carrier plate 101 (A bottom of the carrier plate 101 is press-fitted with the third plastic package body 108), and plastic package the chip 102 to form a first plastic package body 104.

507: Perform electroplating or solder metal on a surface that is of the second plastic package body 105 and that is away from the carrier plate 101 to form a pad 107.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A system-in-package structure, wherein the system-in-package structure comprises: a carrier plate, a chip, a passive component, a first plastic package body and a second plastic package body, wherein
the chip is disposed on a first surface of the carrier plate, the passive component is disposed on a second surface of the carrier plate, and the first surface is disposed opposite to the second surface;
the first plastic package body for packaging the chip is formed on the first surface, and a surface that is of the chip and that is away from the carrier plate is exposed to the first plastic package body; and
the second plastic package body for packaging the passive component is formed on the second surface.

2. The system-in-package structure according to claim 1, wherein the surface that is of the chip and that is away from the carrier plate and a surface that is of the first plastic package body and that is away from the carrier plate are on a same plane.

3. The system-in-package structure according to claim 1 or 2, wherein the system-in-package structure further comprises: an interconnecting component, wherein
the interconnecting component is disposed on the second surface of the carrier plate, and the interconnecting component is packaged by the second plastic package body.

4. The system-in-package structure according to claim 3, wherein the system-in-package structure further comprises: a pad, wherein
the pad is disposed on a surface that is of the second plastic package body and that is away from the carrier plate, and the pad is electrically connected to the passive component and the interconnecting component separately.

5. The system-in-package structure according to claim 3 or 4, wherein the carrier plate is a substrate comprising a metal layer, and the chip, the passive component, and the interconnecting component are electrically connected by using the metal layer.

6. The system-in-package structure according to claim 3 or 4, wherein the carrier plate is a metal frame, and the chip, the passive component, and the interconnecting component are electrically connected by using the metal frame.

7. A packaging method of a system-in-package structure, wherein the packaging method comprises:
mounting a chip on a first surface of a carrier plate;
plastic packaging the chip to form a first plastic package body on the first surface, wherein a surface that is of the chip and that is away from the carrier plate is exposed to the first plastic package body;
mounting a passive component on a second surface of the carrier plate, wherein the first surface is disposed opposite to the second surface; and
plastic packaging the passive component to form a second plastic package body on the second surface.

8. The packaging method according to claim 7, wherein the surface that is of the chip and that is away from the carrier plate and a surface that is of the first plastic package body and that is away from the carrier plate are on a same plane.

9. The packaging method according to claim 8, wherein the mounting a passive component on a second surface of the carrier plate comprises:
mounting the passive component and an interconnecting component on the second surface of the carrier plate.

10. The packaging method according to claim 9, wherein the plastic packaging the passive component to form a second plastic package body on the second surface comprises:
plastic packaging the passive component and the interconnecting component to form the second plastic package body on the second surface.

11. The packaging method according to claim 10, wherein after the plastic packaging the passive component and the interconnecting component to form the second plastic package body on the second surface, the packaging method further comprises:
performing electroplating on a surface that is of the second plastic package body and that is away from the carrier plate, to form a pad on the surface that is of the second plastic package body and that is away from the carrier plate, wherein the pad is electrically connected to the passive component and the interconnecting component separately.

12. The packaging method according to claim 10, wherein after the plastic packaging the passive component and the interconnecting component to form the second plastic package body on the second surface, the packaging method further comprises:
soldering metal on a surface that is of the second plastic package body and that is away from the carrier plate, to form a pad on the surface that is of the second plastic package body and that is away from the carrier plate, wherein the pad is electrically connected to the passive component and the interconnecting component separately.

13. The packaging method according to any one of claims 10 to 12, wherein the carrier plate is a substrate comprising a metal layer, and the chip, the passive component, and the interconnecting component are electrically connected by using the metal layer; or
the carrier plate is a metal frame, and the chip, the passive component, and the interconnecting component are electrically connected by using the metal frame.

14. A packaging method of a system-in-package structure, wherein the packaging method comprises:
mounting a passive component in a first inner cavity of a second plastic package body;
press-fitting a carrier plate with the second plastic package body, wherein a second surface of the carrier plate faces toward an opening of an inner cavity of the second plastic package body;
mounting a chip on a first surface of the carrier plate, wherein the first surface is disposed opposite to the second surface; and
plastic packaging the chip to form a first plastic package body on the first surface, wherein a surface that is of the chip and that is away from the carrier plate is exposed to the first plastic package body.

15. The packaging method according to claim 14, wherein the surface that is of the chip and that is away from the carrier plate and a surface that is of the first plastic package body and that is away from the carrier plate are on a same plane.

16. The packaging method according to claim 14 or 15, wherein the method further comprises:
mounting an interconnecting component in the second inner cavity of the second plastic package body.

17. The packaging method according to claim 16, wherein after the plastic packaging the chip to form a first plastic package body on the first surface, the packaging method further comprises:
performing electroplating on a surface that is of the second plastic package body and that is away from the carrier plate, to form a pad on the surface that is of the second plastic package body and that is away from the carrier plate, wherein the pad is electrically connected to the passive component and the interconnecting component separately.

18. The packaging method according to claim 16, wherein after the plastic packaging the chip to form a first plastic package body on the first surface, the packaging method further comprises:
soldering metal on a surface that is of the second plastic package body and that is away from the carrier plate, to form a pad on the surface that is of the second plastic package body and that is away from the carrier plate, wherein the pad is electrically connected to the passive component and the interconnecting component separately.

19. The packaging method according to any one of claims 16 to 18, wherein the carrier plate is a substrate comprising a metal layer, and the chip, the passive component, and the interconnecting component are electrically connected by using the metal layer; or
the carrier plate is a metal frame, and the chip, the passive component, and the interconnecting component are electrically connected by using the metal frame.
